# FASCICULE DE BREVET EUROPEEN

(11) **EP 1 631 982 B1**
(45) Date de publication et mention de la délivrance du brevet: **08.04.2015**
(21) Numéro de dépôt: 04742879.2
(22) Date de dépôt: 03.06.2004
(51) Int. Cl.: H01L 21/762, H01L 21/20

(54) **PROCEDE D'OBTENTION D'UNE COUCHE TRES MINCE PAR AMINCISSEMENT PAR AUTO-PORTAGE PROVOQUE**
VERFAHREN ZUR HERSTELLUNG EINER SEHR DÜNNEN SCHICHT DURCH PROVOZIERTE SELBSTRAGUNG
METHOD FOR PRODUCTION OF A VERY THIN LAYER WITH THINNING BY MEANS OF INDUCED SELF-SUPPORT

(30) Priorité: 06.06.2003 FR 0350207
(43) Date de publication de la demande: 08.03.2006
(73) Titulaire: Commissariat à l'Énergie Atomique et aux Énergies Alternatives, 75015 Paris (FR)
(72) Inventeur: MORICEAU, Hubert, F-38120 SAINT EGREVE (FR); LAGAHE, Chrystelle, F-38134 SAINT JOSEPH DE RIVIERE (FR); BATAILLOU, Benoit, F-73230 Barby (FR)
(74) Mandataire: Ahner, Philippe
(86) Numéro de dépôt international: PCT/FR2004/050212
(87) Numéro de publication internationale: WO 2004/112125

(56) Documents cités:
- WO-A-00/48278
- US-A1- 2002 019 118
- US-B1- 6 246 068
- US-B1- 6 335 258
- US-B1- 6 569 748

## Description

### DOMAINE TECHNIQUE

La présente invention concerne un procédé d'obtention d'une couche mince sur un substrat, permettant notamment l'obtention d'une couche très fine, typiquement inférieure à 0,1 µm.

Elle s'applique en particulier à la réalisation d'une structure de type SOI.

### ETAT DE LA TECHNIQUE ANTERIEURE

Le document FR-A-2 681 472 (correspondant au brevet américain N° 5 374 564) divulgue un procédé d'obtention d'une couche mince de silicium sur un support pour fournir un substrat de type SOI. Le procédé comprend une première étape consistant à implanter un substrat de silicium ou substrat initial par des ions, par exemple des ions hydrogène, pour obtenir une zone fragilisée délimitant, par rapport à la face d'implantation du substrat, une couche mince de silicium. Au cours d'une deuxième étape, un raidisseur ou substrat final est fixé sur la face implantée du substrat initial. La troisième étape consiste à réaliser une séparation de la structure empilée obtenue, au niveau de la zone fragilisée. La séparation procure une couche mince de silicium transférée sur un support, le reste du substrat initial étant réutilisable. Ce procédé est notamment connu sous le nom de Smart Cut^{®}.

Ce procédé permet de réaliser une structure empilée par collage, par exemple par collage moléculaire, supportant une couche mince monocristalline ou polycristalline. Il donne de très bons résultats pour obtenir des transferts de couches minces jusqu'à des épaisseurs aussi fines que 0,1 µm. Cependant, l'obtention de couches minces très fines (typiquement d'épaisseur inférieure à 0,1 µm) peut poser des problèmes dus à l'apparition de défauts, par exemple des cloques, à partir de l'interface de collage.

Une solution pour obtenir des couches minces très fines est d'obtenir d'abord une couche mince plus épaisse puis de retirer le surplus de matériau jusqu'à obtenir l'épaisseur voulue. Cependant, un retrait trop important par les techniques classiques (polissage mécano-chimique ou CMP, traitement thermique, attaque chimique, gravure ionique,...) dégrade l'homogénéité en épaisseur de la couche mince. Cette dégradation est d'autant plus marquée que l'épaisseur à retirer est importante. La qualité, mesurée en termes d'homogénéité en épaisseur de la couche transférée, est donc dégradée par rapport à celle qui peut être obtenue par le procédé Smart Cut^{®}

Un autre problème existe lorsque les matériaux constituant les couches à amincir ont des propriétés qui rendent difficile l'amincissement CMP. C'est le cas par exemple de matériaux trop durs tels que le saphir, le SiC, le diamant. C'est aussi le cas de structures où le collage utilisé pour l'empilement ne permet pas d'utiliser de telles techniques. Par exemple, lorsque l'énergie de collage est trop faible, le CMP ou des gravures chimiques humides ne sont pas utilisables.

La voie de l'exfoliation pure, générée par exemple par implantation et par traitement thermique à haute température et sans raidisseur (approche que l'on retrouve dans le brevet américain N° 6 103 599) risque de laisser une rugosité trop forte pour être récupérable par CMP, recuit hydrogène ou tout autre traitement de surface connu. Ainsi, le phénomène de cloques éclatées (exfoliation) peut laisser en surface des morphologies très difficiles à enlever. On peut assimiler ces cloques éclatées à des successions de marches à des fréquences faibles (largeurs typiques de l'ordre de dizaines de µm).

Le document US 6 246 068 (publié le 12 Juin 2001) décrit un mode de réalisation d'un substrat SOI. Un substrat initial est soumis à une double implantation ionique (de part et d'autre de chacune de ces faces). Des substrats receveurs sont ensuite collés sur chacune de ces faces, et une fracture est réalisée au niveau des zones implantées pour transférer une couche mince du substrat initial sur chacun des substrats receveurs.

En d'autres termes, US 6 246 068 réalise un double Smart Cut™ pour transférer simultanément deux couches minces issues d'un substrat initial vers deux substrats receveurs.

### EXPOSÉ DE L'INVENTION

Pour remédier à ce problème, il est proposé un procédé dans lequel on transfère, sur le support désiré, une couche relativement épaisse de matériau à transférer, puis on l'amincit par implantation et fracture assistée par la présence d'une couche supplémentaire fixée sur cette couche épaisse. On obtient ainsi une couche très mince de bonne qualité sur ledit support.

L'invention a donc pour objet un procédé dont un premier mode de mise en oeuvre est défini par la revendication 1 et dont un deuxième mode de mise en oeuvre est défini par la revendication 2. On obtient ainsi une couche très mince par rapport aux ordres de grandeur des couches transférées classiquement par le procédé Smart Cut^{®} et ce sans problème de bulles au niveau de l'interface et avec une bonne homogénéité d'épaisseur.

L'implantation d'espèces gazeuses dans la couche épaisse de premier matériau peut être réalisée par une ou plusieurs implantations d'espèces gazeuses, identiques ou différentes, choisies parmi des espèces telles que, par exemple, l'hydrogène ou l'hélium.

La couche épaisse de premier matériau peut être composée d'un ou de plusieurs matériaux.

L'implantation d'espèces gazeuses dans le substrat initial peut être une implantation d'ions hydrogène.

Selon le premier mode de mise en oeuvre, l'étape d'implantation d'espèces gazeuses dans la couche épaisse de premier matériau est effectuée après la fracture entre la couche épaisse de premier matériau et le reste du substrat initial.

Selon le deuxième mode de mise en oeuvre, l'étape d'implantation d'espèces gazeuses dans la couche épaisse de premier matériau est effectuée avant l'étape de fixation de la couche épaisse de premier matériau sur le substrat final. D'une façon générale, les implantations sont réalisées de telle sorte que la première fracture (dans le substrat initial) ne gêne pas la deuxième fracture (au sein de la couche épaisse). Par exemple, si les étapes de fracture sont réalisées par traitement thermique, les étapes d'implantation d'espèces gazeuses sont effectuées dans des conditions telles que la fracture entre la couche épaisse de premier matériau et le reste du substrat initial est obtenue à une température inférieure à la température de fracture de ladite structure.

Avantageusement, la fixation de la couche d'auto-portage sur la couche épaisse de premier matériau est réalisée par un dépôt dudit troisième matériau sur la couche épaisse de premier matériau.

La fixation de la couche épaisse de premier matériau sur le substrat final peut être obtenue par un collage par adhésion moléculaire.

Selon une variante de mise en oeuvre, une partie de la couche d'auto-portage étant déposée, l'implantation d'espèces gazeuses dans la couche épaisse de premier matériau est réalisée après ce dépôt effectué en partie.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1F sont des vues en coupe transversale illustrant un premier mode de mise en oeuvre du procédé selon l'invention,
- les figures 2A à 2F sont des vues en coupe transversale illustrant un deuxième mode de mise en oeuvre du procédé selon l'invention,
- la figure 3 est un diagramme explicatif.

### EXPOSÉ DÉTAILLÉ DE MODES DE RÉALISATION PARTICULIERS

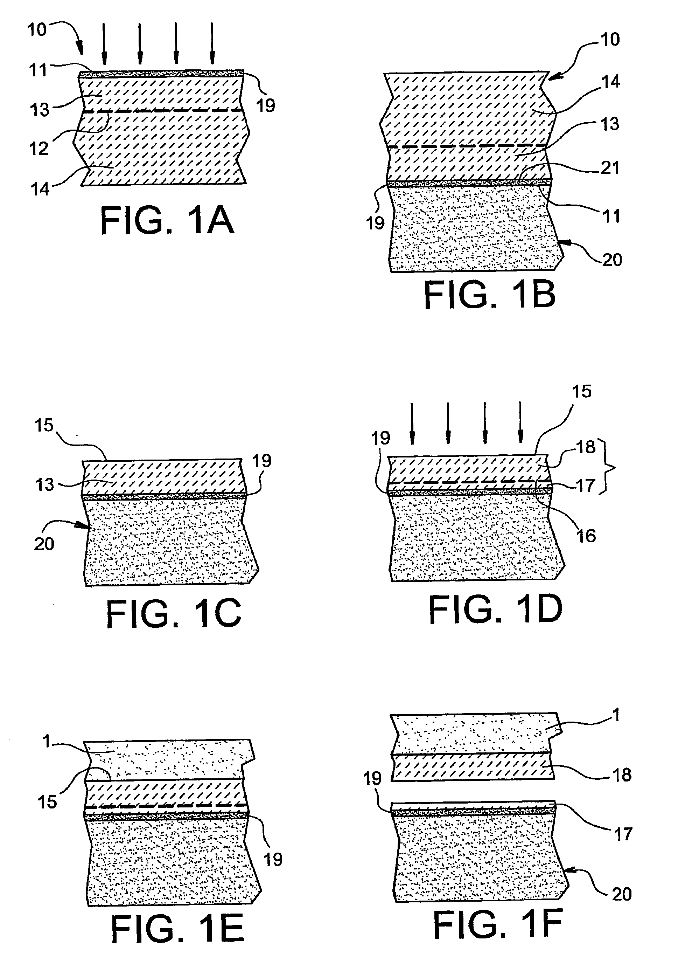

Les figures 1A à 1F illustrent un premier mode de mise en oeuvre du procédé selon l'invention pour l'obtention d'une couche mince de silicium sur un support. Bien entendu, la technique décrite peut être appliquée à d'autres matériaux que le silicium comme par exemple le SiC, le germanium, les matériaux III-V et IV-IV, les nitrures (comme GaN), ou encore d'autres matériaux cristallins, ces matériaux étant pris seuls ou en combinaison.

La figure 1A montre un substrat initial en silicium 10, comportant en surface une couche d'oxyde 19 d'environ 0,05 µm typiquement, dont l'une des faces principales, la face oxydée 11, est soumise à un bombardement ionique uniforme afin de créer une zone fragilisée 12 à une distance déterminée de la face 11. L'implantation est réalisée au moyen d'ions hydrogène accélérés avec une énergie élevée (par exemple 210 keV) afin de créer la zone fragilisée 12 assez profondément par rapport à la face bombardée 11. On délimite ainsi, entre la face 11 et la zone fragilisée 12, une couche 13 d'épaisseur voisine de 1,9 µm, le reste du substrat initial portant la référence 14. La couche 13 peut être appelée couche épaisse. La dose d'ions implantés est choisie conformément au procédé Smart Cut^{®} pour obtenir par la suite une fracture, au niveau de la zone fragilisée, par exemple par un traitement thermique. Le traitement thermique peut être assisté ou remplacé par un traitement mécanique. Par simplification, on parlera par la suite globalement d'un traitement thermique.

La figure 1B montre la fixation de la face 11 du substrat initial 10 sur une face 21 du substrat final 20. La fixation est par exemple obtenue par collage par adhésion moléculaire.

La structure obtenue est alors soumise à un traitement thermique à une température d'environ 480°C. Ce traitement thermique provoque une fracture de la structure au niveau de la zone fragilisée. Après enlèvement du reste 14 du substrat initial on obtient la structure empilée montrée à la figure 1C et comprenant le substrat final 20 auquel adhère la couche épaisse 13 de 1,9 µm d'épaisseur. La couche épaisse 13 présente une face libre 15.

La structure peut en outre être soumise à un traitement thermique pour renforcer son interface de collage. Par exemple, un tel traitement sera effectué à environ 1100°C pendant environ 2 heures.

La face 15 peut être soumise à un traitement de surface (par CMP, recuit hydrogène,...) afin de supprimer la rugosité qu'elle pourrait présenter. Par exemple, une réduction d'épaisseur par CMP de l'ordre de 50 nm permet de conserver une bonne homogénéité d'épaisseur de la couche épaisse.

Une variante peut consister à déposer ou générer thermiquement une fine couche d'oxyde, par exemple de l'ordre de 0,2 µm.

Une seconde implantation ionique est alors effectuée, par exemple par des ions hydrogène. C'est ce que monte la figure 1D. L'énergie d'implantation mise en oeuvre est par exemple de 185 keV et la dose d'ions est choisie pour obtenir par la suite une fracture, au niveau de la zone fragilisée 16 ainsi obtenue, par exemple par un traitement thermique. La zone fragilisée 16 est située à une profondeur d'environ 1,5 µm par rapport à la face 15. Elle sépare la couche épaisse 13 en deux sous-couches 17 et 18, la sous-couche 17 constituant la couche mince désirée.

On réalise ensuite sur la face 15 un dépôt d'une couche 1 dite couche d'auto-portage, comme le montre la figure 1E. Il peut s'agir d'une couche d'oxyde de silicium, d'une épaisseur de 4µm, déposée par PECVD.

Dans le cas où l'on a déposé ou généré, avant la seconde implantation, une fine couche d'oxyde, on vient ici compléter cette couche.

Un traitement thermique peut alors être effectué pour obtenir la fracture, par exemple un recuit isotherme à 600°C. C'est ce que montre la figure 1F. La structure est séparée en une première partie constituée d'un bicouche auto-porté, comprenant la couche d'auto-portage 1 et la sous-couche 18, et une deuxième partie comprenant le substrat final 20 auquel adhère la couche mince 17 par l'intermédiaire de la couche d'oxyde 19. Le bicouche est éventuellement réutilisable.

Le substrat final 20 et la couche mince 17 peuvent alors subir une étape de nettoyage, des étapes d'amincissement de la couche mince et de stabilisation classiques illustrées par exemple dans le document FR-A-2 777 115, dans l'ordre et la combinaison optimale actuelle. La couche mince de silicium peut alors avoir une épaisseur voisine de 100 nm.

Le substrat final utilisé peut être de nature variée. Il peut être en matériau semiconducteur, en matériau isolant ou constitué d'un empilement (par exemple un substrat de silicium recouvert d'une couche d'oxyde de silicium).

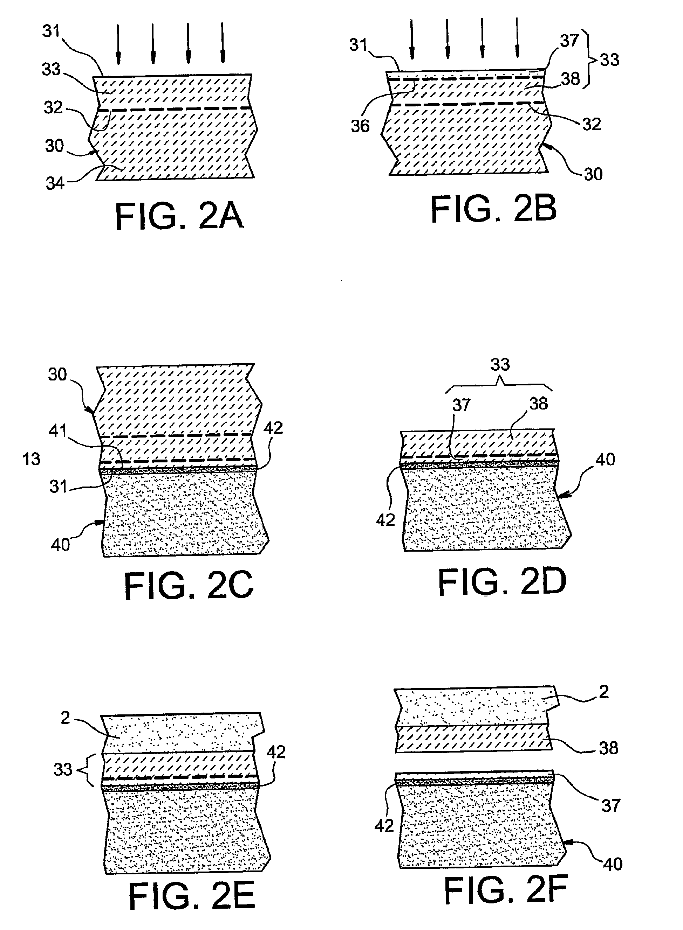

Les figures 2A à 2F illustrent un deuxième mode de mise en oeuvre du procédé selon l'invention pour l'obtention d'une couche mince de silicium sur un support.

La figure 2A montre un substrat initial 30 en silicium dont l'une des faces principales, la face 31, est soumise à un bombardement ionique uniforme afin de créer une zone fragilisée 32 à une distance déterminée de la face 31. Cette face pourrait être pourvue également d'une couche d'oxyde, par exemple de quelques nanomètres d'épaisseur. Comme pour le premier mode de mise en oeuvre de l'invention, l'implantation peut être réalisée par des ions hydrogène d'une énergie de 210 keV. L'implantation délimite entre la face 31 et la zone fragilisée 32, une couche épaisse 33 d'épaisseur voisine de 1,9 µm. Le reste du substrat initial porte la référence 34.

L'étape suivante, représentée à la figure 2B, consiste à réaliser une deuxième implantation ionique au travers de la face 31. Cette deuxième implantation est moins profonde que la première et moins dosée. L'énergie d'implantation peut être de l'ordre de 50 keV. Elle permet de créer une zone fragilisée 36 à l'intérieur de la couche épaisse 33. La zone fragilisée 36 délimite, par rapport à la face 31, une couche mince 37. Le reste de la couche épaisse 33, ou sous-couche, porte la référence 38.

La figure 2C montre la fixation de la face 31 du substrat initial 30 sur une face 41 du substrat final 40 comportant en surface une couche d'oxyde 42 de 0,05 µm d'épaisseur typiquement. La fixation peut être obtenue par adhésion moléculaire.

La structure obtenue est alors soumise par exemple à un traitement thermique à une température relativement basse, par exemple 430°C, pour obtenir une fracture au niveau de la première zone fragilisée, c'est-à-dire la zone 32. Les conditions d'implantation des deux zones fragilisées ont été prévues pour ne pas générer de fracture, voire d'exfoliation, dans la deuxième zone fragilisée. L'avantage d'avoir réalisé la deuxième implantation avant le transfert de la couche épaisse est que, de ce fait, cette deuxième implantation est moins profonde et réalisée à travers une surface normalement de bonne qualité (meilleure que celle d'une face obtenue par fracture). Ceci permet donc d'obtenir une zone fragilisée plus faible et donc une rugosité après fracture finale également plus faible. La structure obtenue est représentée à la figure 2D.

A ce stade du procédé, l'étape de traitement de surface peut être supprimée dans la mesure où on peut faire le dépôt de la couche d'auto-portage directement. Toutefois, un traitement de surface minimum peut être effectué pour supprimer tout ou partie de la rugosité. Il peut s'agir d'un CMP, d'un recuit par exemple sous hydrogène ou tout autre atmosphère compatible connue de l'homme du métier, d'une attaque chimique humide ou d'une gravure ionique. Le traitement de surface permet un retrait de quelques nm à quelques dizaines de nm, conservant ainsi une bonne homogénéité en épaisseur. Ce traitement de surface minimum permet, dans le cas d'une couche d'auto-portage en SiO₂, d'avoir une interface Si- SiO₂ enterrée peu rugueuse.

On réalise ensuite sur la couche épaisse 33 un dépôt d'une couche 2 dite couche d'auto-portage comme le montre la figure 2E. Comme précédemment, il peut s'agir d'une couche d'oxyde de silicium, d'une épaisseur de 4 µm, déposée par PECVD.

Un traitement thermique peut alors être effectué pour obtenir la fracture, par exemple un recuit isotherme à 600°C. C'est ce que montre la figure 2F. La structure est séparée en une première partie constituée d'un bicouche auto-porté, comprenant la couche d'auto-portage 2 et la sous-couche 38, et une deuxième partie comprenant le substrat final 40 auquel adhère la couche mince 37 par l'intermédiaire de la couche d'oxyde 42. Le bicouche est éventuellement réutilisable.

Comme précédemment des étapes de nettoyage et de finition peuvent être effectuées sur la structure empilée obtenue.

Ces deux modes de réalisation laissent suggérer que certaines étapes peuvent être combinées et/ou interverties. Par exemple, on peut déposer tout ou partie de la couche d'auto-portage et effectuer la deuxième implantation après ce dépôt. Dans ce cas, l'énergie d'implantation est corrigée pour en tenir compte.

La couche auto-portée peut être en oxyde de silicium ou en d'autres matériaux, comme par exemple Si₃N₄, SiOₓ, SiₓN_{y}, SiₓN_{y}O_{z}, Al₂O₃, SiC, le saphir, le diamant, etc....

L'épaisseur de la couche auto-portée peut être prévue à partir d'expérimentations. Dans le cas d'une couche auto-portée en SiO₂ déposée sur une couche épaisse en silicium, l'expérimentation suivante a été réalisée pour évaluer l'effet de l'épaisseur d'oxyde déposé sur la température de recuit, épaisseur nécessaire pour obtenir la fracture de la couche de silicium auto-portée. Les conditions d'implantation étaient les suivantes : énergie d'implantation 76 keV, dose d'implantation 6.10¹⁶ ions H⁺/cm² au travers d'un film de protection en SiO₂ de 400 nm d'épaisseur.

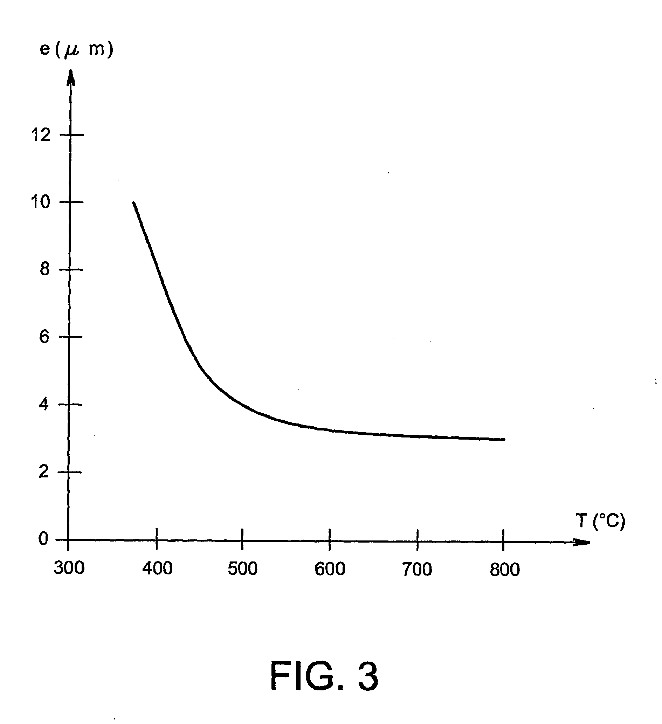

La figure 3 est un diagramme dont l'axe des ordonnées représente l'épaisseur e du dépôt de SiO₂ et l'axe des abscisses la température T de recuit. La courbe représentée sur ce diagramme délimite la zone où on obtient un transfert de la couche de silicium auto-portée (la zone située au-dessus de la courbe) de la zone où il se produit un « cloquage » de la couche de silicium (la zone située en-dessous de la courbe).

De ce diagramme, on peut conclure que la température de séparation (ou de fracture) avec transfert d'un bicouche auto-porté dépend effectivement de l'épaisseur d'oxyde déposé. La température est d'autant plus élevée que l'épaisseur d'oxyde est fine. En fait, il faut ajouter à cette épaisseur d'oxyde, l'épaisseur de la couche de silicium fracturée. On peut donc en particulier en déduire l'épaisseur minimum de couche d'oxyde nécessaire pour que la fracture soit induite à une certaine température. Il apparaît donc que pour 4 µm d'oxyde déposé, l'épaisseur « seuil » de fracture à 600°C est dépassée.

Il est donc possible de contrôler la procédure d'amincissement par le contrôle de l'épaisseur de la couche d'auto-portage déposée, évitant ainsi les phénomènes de « cloquage » et d'exfoliation induits pour une épaisseur de couche déposée inférieure à l'épaisseur « seuil ».

## Revendications

1. Procédé d'obtention d'une couche mince en un premier matériau (17) sur un substrat en un deuxième matériau dit substrat final (20), comprenant les étapes successives suivantes :
- implantation d'espèces gazeuses dans un substrat initial (10) permettant d'y créer une première zone fragilisée (12) délimitant une couche épaisse de premier matériau (13) du reste (14) du substrat initial ;
- fixation du substrat initial, par l'une des faces principales de la couche épaisse de premier matériau (13), sur le substrat final (20) selon une interface,
- enlèvement du reste du substrat initial (14) par fracture entre la couche épaisse de premier matériau (13) et le reste (14) du substrat initial au niveau de la première zone fragilisée (12);
- implantation d'espèces gazeuses dans la couche épaisse de premier matériau (13) pour créer une deuxième zone fragilisée (16) séparant la couche épaisse en une première (17) et une seconde (18) sous-couche, la première sous-couche présente entre l'interface et la zone fragilisée formant ladite couche mince (17),
- dépôt sur la face libre (15) de la couche épaisse de premier matériau (13) fixée au substrat final (20) d'une couche d'un troisième matériau dite couche d'auto-portage (1),
- fracture au sein de la structure constituée par le substrat final (20), la couche épaisse de premier matériau (13) et la couche de troisième matériau (1), au niveau de la deuxième zone fragilisée (16) pour séparer la structure en une première partie comprenant la couche d'auto-portage (1) et la deuxième sous-couche (18) et une seconde partie comprenant le substrat final supportant ladite couche mince.

2. Procédé d'obtention d'une couche mince en un premier matériau (37) sur un substrat en un deuxième matériau dit substrat final (40), comprenant les étapes successives suivantes :
- implantation d'espèces gazeuses dans un substrat initial (30) permettant d'y créer une première zone fragilisée (32) délimitant une couche épaisse de premier matériau (33) du reste (34) du substrat initial ;
- implantation d'espèces gazeuses dans la couche épaisse de premier matériau (33) pour créer une deuxième zone fragilisée (36) séparant la couche épaisse en une première (37) et une seconde (38) sous-couche, la première sous-couche formant ladite couche mince (17),
- fixation du substrat initial, par l'une des faces principales de la couche épaisse de premier matériau (33), sur le substrat final (40),
- enlèvement du reste du substrat initial (34) par fracture entre la couche épaisse de premier matériau (33) et le reste (34) du substrat initial au niveau de la première zone fragilisée (32);
- dépôt sur la face libre de la couche épaisse de premier matériau (33) fixée au substrat final (40) d'une couche d'un troisième matériau dite couche d'auto-portage (2),
- fracture au sein de la structure constituée par le substrat final (40), la couche épaisse de premier matériau (33) et la couche de troisième matériau (2), au niveau de la deuxième zone fragilisée (36) pour séparer la structure en une première partie comprenant la couche d'auto-portage (2) et la deuxième sous-couche (38) et une seconde partie comprenant le substrat final supportant ladite couche mince.

3. Procédé selon l'une des revendications 1 et 2, **caractérisé en ce que** l'implantation d'espèces gazeuses dans la couche épaisse de premier matériau (13, 33) est réalisée par une ou plusieurs implantations d'espèces gazeuses identiques ou différentes.

4. Procédé selon la revendication 3, **caractérisé en ce que** lesdites espèces gazeuses sont choisies parmi l'hydrogène et l'hélium.

5. Procédé selon l'une des revendications 1 et 2, **caractérisé en ce que** l'implantation d'espèces gazeuses dans le substrat initial est une implantation d'ions hydrogène.

6. Procédé selon la revendication 2, **caractérisé en ce que** les étapes de fracture étant réalisées par un traitement thermique, les étapes d'implantation d'espèces gazeuses sont effectuées dans des conditions telles que la fracture entre la couche épaisse de premier matériau (33) et le reste (34) du substrat initial (30) est obtenue à une température inférieure à la température de fracture de ladite structure.

7. Procédé selon l'une quelconque des revendications 1 à 5, **caractérisé en ce que** la fixation de la couche épaisse de premier matériau (13, 33) sur le substrat final (20, 40) est obtenue par un collage par adhésion moléculaire.

8. Procédé selon l'une des revendications 1 et 2, **caractérisé en ce que**, une partie de la couche d'auto-portage (1) étant déposée, l'implantation d'espèces gazeuses dans la couche épaisse de premier matériau (13) est réalisée après ce dépôt effectué en partie.

## Patentansprüche

1. Verfahren zur Herstellung einer dünnen Schicht aus einem ersten Material (17) auf einem Substrat aus einem zweiten Material, genannt finales Substrat (20), umfassend die folgenden aufeinanderfolgenden Schritte:
- Implantieren von gasförmigen Sorten in einem anfänglichen Substrat (10), was es ermöglicht, dort eine erste fragilisierte Zone (12) zu erzeugen, die eine dicke Schicht aus erstem Material (13) vom Rest (14) des anfänglichen Substrats abgrenzt;
- Befestigen des anfänglichen Substrats an einer der Hauptflächen der dicken Schicht aus erstem Material (13) an dem finalen Substrat (20) entlang einer Grenzfläche,
- Entfernen des Rests des anfänglichen Substrats (14) durch Brechen zwischen der dicken Schicht aus erstem Material (13) und dem Rest (14) des anfänglichen Substrats im Bereich der ersten fragilisierten Zone (12);
- Implantieren von gasförmigen Sorten in der dicken Schicht aus erstem Material (13), um eine zweite fragilisierte Zone (16) zu erzeugen, die die dicke Schicht in eine erste (17) und eine zweite (18) Teilschicht separiert, wobei die erste Teilschicht, die zwischen der Grenzfläche und der fragilisierten Zone vorhanden ist, die dünne Schicht (17) bildet,
- Aufbringen, auf der freien Fläche (15) der dicken Schicht aus erstem Material (13), die am finalen Substrat (20) befestigt ist, einer Schicht aus einem dritten Material, genannt Selbsttragungsschicht (1),
- Brechen innerhalb der Struktur, die gebildet ist durch das finale Substrat (20), die dicke Schicht aus erstem Material (13) und die Schicht aus drittem Material (1), im Bereich der zweiten fragilisierten Zone (16), um die Struktur in einen ersten Teil, umfassend die Selbsttragungsschicht (1) und die zweite Teilschicht (18), und einen zweiten Teil zu separieren, der das finale Substrat umfaßt, welches die dünne Schicht trägt.

2. Verfahren zur Herstellung einer dünnen Schicht aus einem ersten Material (37) auf einem Substrat aus einem zweiten Material, genannt finales Substrat (40), umfassend die folgenden aufeinanderfolgenden Schritte:
- Implantieren von gasförmigen Sorten in einem anfänglichen Substrat (30), was es erlaubt, dort eine erste fragilisierte Zone (32) zu erzeugen, die eine dicke Schicht aus erstem Material (33) vom Rest (34) des anfänglichen Substrats abgrenzt;
- Implantieren von gasförmigen Sorten in der dicken Schicht aus erstem Material (33), um eine zweite fragilisierte Zone (36) zu erzeugen, die die dicke Schicht in eine erste (37) und eine zweite (38) Teilschicht separiert, wobei die erste Teilschicht die dünne Schicht (17) bildet,
- Befestigen des anfänglichen Substrats an einer der Hauptflächen der dicken Schicht aus erstem Material (33) an dem finalen Substrat (40),
- Entfernen des Rests des anfänglichen Substrats (34) durch Brechen zwischen der dicken Schicht aus erstem Material (33) und dem Rest (34) des anfänglichen Substrats im Bereich der ersten fragilisierten Zone (32);
- Aufbringen, auf der freien Fläche der dicken Schicht aus erstem Material (33), die an dem finalen Substrat (40) befestigt ist, einer Schicht aus einem dritten Material, genannt Selbsttragungsschicht (2),
- Brechen innerhalb der Struktur, die gebildet ist durch das finale Substrat (40), die dicke Schicht aus erstem Material (33) und die Schicht aus drittem Material (2), im Bereich der zweiten fragilisierten Zone (36), um die Struktur in einen ersten Teil, umfassend die Selbsttragungsschicht (2) und die zweite Teilschicht (38), und einen zweiten Teil zu separieren, der das finale Substrat umfaßt, welches die dünne Schicht trägt.

3. Verfahren nach einem der Ansprüche 1 und 2, **dadurch gekennzeichnet, dass** das Implantieren von gasförmigen Sorten in der dicken Schicht aus erstem Material (13, 33) realisiert wird durch eine oder mehrere Implantierungen von identischen oder unterschiedlichen gasförmigen Sorten.

4. Verfahren nach Anspruch 3, **dadurch gekennzeichnet, dass** die gasförmigen Sorten ausgewählt sind aus Wasserstoff und Helium.

5. Verfahren nach einem der Ansprüche 1 und 2, **dadurch gekennzeichnet, dass** die Implantierung von gasförmigen Sorten in dem anfänglichen Substrat eine Implantierung von Wasserstoffionen ist.

6. Verfahren nach Anspruch 2, **dadurch gekennzeichnet, dass** die Schritte des Brechens realisiert werden durch eine thermische Behandlung, wobei die Schritte des Implantierens von gasförmigen Sorten unter Bedingungen derart durchgeführt werden, dass das Brechen zwischen der dicken Schicht aus erstem Material (33) und dem Rest (34) des anfänglichen Substrats (30) bei einer Temperatur erreicht wird, die niedriger ist als die Brechungstemperatur der Struktur.

7. Verfahren nach einem der Ansprüche 1 bis 5, **dadurch gekennzeichnet, dass** das Befestigen der dicken Schicht aus erstem Material (13, 33) auf dem finalen Substrat (20, 40) durch ein Kleben mittels molekularer Adhäsion erzielt wird.

8. Verfahren nach einem der Ansprüche 1 und 2, **dadurch gekennzeichnet, dass** dann, wenn ein Teil der Selbsttragungsschicht (1) aufgebracht wird, die Implantierung von gasförmigen Sorten in der dicken Schicht aus erstem Material (13) nach dieser teilweise durchgeführten Aufbringung realisiert wird.

## Claims

1. Process for obtaining a thin layer made of a first material (17) on a substrate made of a second material called the final substrate (20), including the following sucessive steps:
- implantation of gaseous species in an initial substrate (10) to create therein a first weakened zone (12) delimiting a thick layer of first material (13) from the remainder (14) of the initial substrate,
- fixation of the initial substrate, by one of the main faces of the thick layer of first material (13), on the final substrate (20) at an interface,
- removal of the remainder (14) of the initial substrate by fracture between the thick layer of first material and the remainder (14) of the initial substrate at the first first weakened zone (12),
- implantation of gaseous species in the thick layer of first material (13) to create a second weakened zone (16) separating the thick layer in a first (17) and a second (18) sub-layer, the first sub-layer present between the interface and the weakened zone forming said thin layer (17),
- deposition of a layer of third material called the self-supporting layer (1) on the free face (15) of the thick layer made of first material (13) fixed to the final substrate (20),
- fracture within the structure composed of the final substrate (20), the thick layer of first material (13) and the layer of third material (1), at the second weakened zone (16) to separate the structure in a first part which comprises the self-supporting layer (1) and the second sub-layer (18) and a second part which comprises the final substrate supporting said thin layer.

2. Process for obtaining a thin layer made of a first material (37) on a substrate made of a second material called the final substrate (40), including the following sucessive steps:
- implantation of gaseous species in an initial substrate (30) to create therein a first weakened zone (32) delimiting a thick layer of first material (33) from the remainder (34) of the initial substrate,
- implantation of gaseous species in the thick layer of first material (33) to create a second weakened zone (36) separating the thick layer in a first (37) and a second (38) sub-layer, the first sub-layer forming said thin layer (17),
- fixation of the initial substrate, by one of the main faces of the thick layer of first material (33), on the final substrate (40),
- removal of the remainder (34) of the initial substrate by fracture between the thick layer of first material and the remainder (34) of the initial substrate at the first first weakened zone (32),
- deposition of a layer of third material called the self-supporting layer (2) on the free face of the thick layer made of first material (33) fixed to the final substrate (40),
- fracture within the structure composed of the final substrate (40), the thick layer of first material (33) and the layer of third material (2), at the second weakened zone (36) to separate the structure in a first part which comprises the self-supporting layer (2) and the second sub-layer (38) and a second part which comprises the final substrate supporting said thin layer.

3. Process according to claim 1 or claim 2, **characterised in that** the gaseous species are implanted in the thick layer of first material (13, 33) by one or several implantations of identical or different gaseous species.

4. Process according to claim 3, **characterised in that** said gaseous species are chosen from among hydrogen and helium.

5. Process according to claim 1 or claim 2, **characterised in that** the implantation of gaseous species in the initial substrate is an implantation of hydrogen ions.

6. Process according to claim 2, **characterised in that** the fracture steps are done by a heat treatment, the steps to implant gaseous species are done under conditions such that the fracture between the thick layer of first material (33) and the remainder (34) of the initial substrate (30) is obtained at a temperature less than the fracture temperature of said structure.

7. Process according to any one of claims 1 to 5, **characterised in that** the thick layer of first material (13, 33) is fixed on the final substrate (20, 40) by molecular bonding.

8. Process according to claim 1 or claim 2, **characterised in that** part of the self-supporting layer (1) is deposited, and the gaseous species are implanted in the thick layer of first material (13) after this partial deposit.
